# EUROPEAN PATENT SPECIFICATION

(11) **EP 2 966 951 B1**
(45) Date of publication and mention of the grant of the patent: **01.11.2017**
(21) Application number: 13876881.7
(22) Date of filing: 06.03.2013
(51) Int. Cl.: H05K 13/04, H05K 13/02

(54) **ELECTRONIC CIRCUIT COMPONENT MOUNTING MACHINE**
KOMPONENTENMONTAGESYSTEM FÜR ELEKTRONISCHE SCHALTUNGEN
MACHINE DE MONTAGE DE COMPOSANT DE CIRCUIT ÉLECTRONIQUE

(43) Date of publication of application: 13.01.2016
(73) Proprietor: Fuji Machine Mfg. Co., Ltd., Chiryu-shi, Aichi 472-8686 (JP)
(72) Inventor: NOZAWA, Mizuho, Chiryu-shi Aichi 472-8686 (JP)
(74) Representative: Grünecker Patent- und Rechtsanwälte PartG mbB
(86) International application number: PCT/JP2013/056179
(87) International publication number: WO 2014/136231

(56) References cited:
- EP-A2- 1 041 870
- JP-A- 2004 112 003
- JP-A- 2008 270 332
- JP-A- 2009 010 205
- JP-A- 2012 164 881

## Description

### Technical Field

The present invention relates to an electronic-circuit-component mounting machine that mounts an electronic circuit component on a circuit substrate, and particularly, to an electronic-circuit-component mounting machine in which a rotary type mounting head including a plurality of suction nozzles and a component feeder which are held on a rotor, moves with respect to a circuit substrate holding device, and reception and mounting of the electronic circuit component from the component feeder is performed in parallel by the plurality of suction nozzles.

### Background Art

In the related art, PTL 1 discloses a rotary type mounting head including a plurality of suction nozzles that is held so as to move up and down in a plurality of positions on a circumference around a rotation axis line of a rotor. The rotary type mounting head is moved with respect to a component supply device and a circuit board holding device by a mounting head moving device. After receiving electronic circuit components from the component supply device, all the suction nozzles move to the circuit board holding device, and mount the electronic circuit components on a circuit board. The plurality of suction nozzles are revolved by rotation of the rotor, and perform reception of the electronic circuit components from the component supply device and mounting of the electronic circuit components on the circuit board, in a component reception and mounting position that is one of a plurality of revolving positions. At the time of receiving the electronic circuit components, negative pressure is supplied to the suction nozzles, and at the time of mounting, supply of the negative pressure to the suction nozzles is cut off and positive pressure is supplied. For this reason, a negative pressure control valve and a positive pressure control valve are provided in the rotor, with regard to each of the plurality of suction nozzles. The control valves are switched by a valve switching device provided in portions corresponding to the component reception and mounting position of a head body. A similar rotary type mounting head is disclosed in PTL 2.

### Citation List

### Patent Literature

PTL 1: JP-A-9-162597
PTL 2: EP 1 041 870 A2

### Summary of Invention

### Technical Problem

The present invention is made in view of the above circumstances, and aims to improve practicality of an electronic-circuit-component mounting machine which includes a plurality of suction nozzles and a rotary type mounting head that is moved with respect to a circuit substrate holding device.

### Solution to Problem

The above object is solved by an electronic-circuit-component mounting machine including: (A) a circuit substrate holding device that holds a circuit substrate; (B) a component supply device that supplies an electronic circuit component; (C) a positive pressure source that supplies positive pressure; (D) a negative pressure source that supplies negative pressure; (E) a rotary type mounting head that includes (a) a rotor that is rotatable around an axis line, (b) a plurality of suction nozzles that are held so as to move up and down in an axis direction at a plurality of positions on a circumference around the axis line of the rotor, and pick up and hold an electronic circuit component using the negative pressure, (c) a rotor rotation device that intermittently rotates the rotor, thereby revolving the plurality of suction nozzles which are held on the rotor, and stops the respective suction nozzles at predetermined revolving positions, and (d) a head body that holds the rotor rotation device and the rotor; (F) a mounting head moving device that moves the rotary type mounting head with respect to the circuit substrate holding device; (G) and a component mounting control device that controls the rotary type mounting head and the mounting head moving device such that the electronic circuit components are received from the component supply device by the plurality of suction nozzles that are held on the rotor and mounted on the substrate held by the circuit substrate holding device, in which the rotary type mounting head further includes (e) a component feeder that, in a state in which the electronic circuit components which are accommodated in a component accommodation section are aligned in a row, sequentially supplies the electronic circuit components from the component supply section to a suction nozzle that is stopped at a component reception position that is one of the predetermined revolving positions among the plurality of suction nozzles, and serves as at least a portion of the component supply device; (f) a positive pressure control valve that sets a suction nozzle, among the plurality of suction nozzles, which has revolved to the vicinity of a component mounting position that is one of the predetermined revolving positions according to the intermittent rotation of the rotor to a state of being connectable with the positive pressure source; (g) a negative pressure control valve that sets an suction nozzle, among the plurality of suction nozzles, which has revolved to the vicinity of the component reception position according to the intermittent rotation of the rotor to a state of being connectable with the negative pressure source; (h) a nozzle advancing and retreating device that makes an suction nozzle which is revolved to the vicinity of the component reception position and the vicinity of the component mounting position, among the plurality of suction nozzles that are held on the rotor, advance and retreat in the axis direction with respect to the rotor; and (i) a nozzle and positive pressure source connecting and blocking section that is provided in a non-rotation section that does not rotate regardless of rotation of the rotor, among a plurality of stop positions in which each of the plurality of suction nozzles that are held on the rotor by the intermittent rotation of the rotor is stopped, in a first setting angle area corresponding to one or more stop positions including the component mounting position, allows a sufficient connection between an suction nozzle at a stop position corresponding to the first setting angle area and the positive pressure source, and in a second setting angle area corresponding to one or more stop positions including the component reception position, blocks connection between an suction nozzle at a stop position corresponding to the second setting angle area and the positive pressure source.

"Allows a sufficient connection between a suction nozzle ... and the positive pressure source" described above does not mean that a slight connection is made, and means that connection is facilitated by a sufficient flow passage area in order to achieve the purpose of connection.

The circuit substrate includes, for example, (i) a printed wire board on which electronic circuit components are not mounted yet, (ii) a printed circuit board having one surface on which electronic circuit components are mounted and electrically connected to each other, and the other surface on which electronic circuit components are not mounted, (iii) a substrate on which a bare chip is mounted and configures a board with a chip, (iv) a substrate on which electronic circuit components that include ball grid arrays are mounted, (v) a substrate that does not shape a flat plate and has a three-dimensional shape, or the like.

For example, a bulk feeder, a tape feeder, a stick feeder, or the like can be employed as the component feeder.

The rotor may be rotatable around a vertical axis line, and may be rotatable around an axis line that is tilted with respect to the vertical axis line. In addition, the suction nozzle may be held so as to move up and down in a direction parallel to a rotation axis line of the rotor, by the rotor, and may be held so as to move up and down in an intersecting direction.

A position of the suction nozzle is defined by a position of an axis line of the suction nozzle.

### Advantageous Effects of Invention

In a rotary type mounting head that includes a plurality of suction nozzle and a component feeder which are held on a rotor and that is moved with respect to a circuit substrate holding device, one of the plurality of suction nozzles is revolved to a component mounting position that is one of a plurality of revolving positions by rotation of the rotor, the rotary type mounting head moves with respect to the circuit substrate holding device, and thereby the rotary type mounting head is located on a component mounting point of the circuit substrate and mounts an electronic circuit component on the circuit substrate. This technology is the same as that of a rotary type mounting head of the related art, but one suction nozzle different from the plurality of suction nozzles is revolved to a component reception position, parallel to the mounting operation, and receives electronic circuit components from the component feeder. In this way, a receiving operation is performed in parallel to the mounting operation of the electronic circuit components, and thus mounting of the electronic circuit components is efficiently performed.

At the time of mounting a component, positive pressure is supplied to the suction nozzle, and thereby negative pressure is positively extinguished and the electronic circuit component is rapidly released. For this reason, when the suction nozzle that mounts the electronic circuit component on the circuit substrate is then moved to the component reception position, a negative pressure control valve enters a negative pressure source connection blocking state in which connection between the suction nozzle and the negative pressure source is blocked, and a positive pressure control valve enters a positive pressure source connectable state in which the suction nozzle is in a state of being connectable with the positive pressure source. At the time of receiving a component, the positive pressure control valve enters a positive pressure source connection blocking state, and the negative pressure control valve enters a negative pressure source connectable state. If switching of the positive pressure control valve and the negative pressure control valve is performed in parallel to the approach of the suction nozzle in the component reception position with respect to the component feeder, the time required for receiving the component can be reduced, and mounting efficiency can be further improved. However, in this case, compressed air is blown from the suction nozzle until switching of the control valve is performed, and there is risk in which the electronic circuit component that is supplied by the component feeder is blown away.

In contrast to this, after connecting with the negative pressure source in the component reception position, the suction nozzle approaches the component feeder, or connection between the suction nozzle and the positive pressure source is cut off. If, in a state in which an internal pressure of the suction nozzle is set to atmospheric pressure, the suction nozzle approaches the component feeder and connects with the negative pressure source, there is no risk in which the electronic circuit component is blown away, but time required for receiving is increased.

In addition, an electromagnetic valve that integrally allows and cuts connection between all of a plurality of positive pressure control valves and the positive pressure source is provided, after all the suction nozzles mount the electronic circuit components, connection between all the positive pressure control valves and the positive pressure source is cut, while all the suction nozzles receive the electronic circuit components, if positive pressure is not supplied, at the time of receiving the components, the electronic circuit components are not blown away, the suction nozzle can be connected with the negative pressure source in parallel to approaching the component feeder, but picking up and mounting cannot be performed in parallel.

Furthermore, an electromagnetic valve is provided with regard to each of a plurality of suction nozzles, and if connection and blocking between a positive pressure source and a negative pressure source of the suction nozzle is individually performed at an arbitrary time, after mounting the component, supply of positive pressure to the suction nozzle is blocked before receiving the component, and the suction nozzle can have atmospheric pressure. Thereby, the electronic circuit component is not blown away, the suction nozzle can be connected with the negative pressure source during approaching the component feeder, and picking up and mounting can be performed in parallel. However, in this case, a configuration of the rotary type mounting head is complicated and the cost is increased.

In contrast to this, in the electronic-circuit-component mounting machine according to the present invention, if the suction nozzle enters a state of being located at a stop position corresponding to a second setting angle area, according to rotation of the rotor, connection with the positive pressure source is blocked. In a state that the positive pressure control valve enters a positive pressure source connectable state, connection between the suction nozzle and the positive pressure source is blocked, and at the time of receiving the component, the suction nozzle can approach the component feeder in a state in which positive pressure is not supplied. Thus, while approaching the component feeder of the suction nozzle, even if the negative pressure control valve is switched from a negative pressure source connection blocking state to a negative pressure connectable state, the suction nozzle can pick up the electronic circuit component without blowing. Meanwhile, connection with the positive pressure source is allowed with regard to the suction nozzle that is located at a component mounting position that is a stop position corresponding to the first setting angle area, and thereby positive pressure is supplied, and the electronic circuit component is rapidly released.

In this way, according to the present invention, a nozzle and positive pressure source connecting and blocking section is provided in the rotary type mounting head, and thereby even if an electromagnetic valve is not provided with regard to each of the plurality of suction nozzles, connection with the positive pressure source can be mechanically blocked before the suction nozzle reaches the component reception position, the electronic circuit component is not blown, switching of the control valve can be performed while approaching the component feeder, receiving and mounting of the components can be performed in parallel, the electronic circuit component can be rapidly released by supplying positive pressure to the suction nozzle in the component mounting position. According to this, mounting efficiency is increased, and an electronic-circuit-component mounting machine with an inexpensive configuration and a simple configuration is obtained.

In the electronic-circuit-component mounting machine according to the present invention, it is preferable that a plurality of radial passages is formed in the rotor in a state of extending in a radial shape from a central hole of the rotor to a plurality of positions corresponding to each of the plurality of suction nozzles, and the nozzle and positive pressure source connecting and blocking section includes (a) a connection control section having a cutout section that is fit to the central hole so as to be relatively rotatably to the central hole, and sets a radial passage, among the plurality of radial passages, corresponding to one or more suction nozzles at a stop position corresponding to the first setting angle area to a fully open state, according to rotation of the rotor, and having a closing section that sets a radial passage corresponding to one or more suction nozzles at a stop position corresponding to the second setting angle area, to a fully closed state; and (b) a positive pressure source connection passage that makes the cutout section connect with the positive pressure source, regardless of a rotation position of the rotor.

In the electronic-circuit-component mounting machine of the preferable aspect, the first setting angle area is set by taking into account connection between the radial passage and the cutout section. The cutout section is configured to have a shape that allows connection with the entire opening on a central hole side of at least one radial passage, and dimension, around a rotation axis line of the rotor and in a direction parallel to the rotation axis line. When the radial passage revolves toward the cutout section according to rotation of the rotor, a connection area with respect to the cutout section of an opening on the central hole side is gradually increased, and the entire opening enters a state of being located inside the cutout section. In addition, when the radial passage is separated from the cutout section according to the rotation of the rotor, a connection area with respect to the cutout section of the opening is gradually decreased, and entirety is in a state of deviating from the cutout section. If a corresponding radial passage starts to connect with the cutout section even at a portion, the suction nozzle connects with the positive pressure source, and while the corresponding radial passage connects with the cutout section even at a portion, it can be said that the suction nozzle connects with the positive pressure source, but even if, in this state, the positive pressure control valve is in a state in which the suction nozzle can be connected with the positive pressure source, rapid supply of positive pressure is not achieved. Thus, the first setting angle area is set to an angle area in which the entire opening on the central hole side of the radial passage corresponding to one or more suction nozzles located at a stop position corresponding to the angle area is surely located inside the cutout section.

In addition, when an opening on a central hole side of a radial passage corresponding to one or more suction nozzles located on a stop position corresponding to the angle area is fully closed by a closing section, and a negative pressure control valve makes an suction nozzle that is revolved to the vicinity of a component reception position connect with a negative pressure source, the second setting angle area is set to an angle area in which supply of positive pressure is surely and completely blocked.

In this way, a cutout section of a connection control section may be able to guarantee that a radial passage corresponding to the suction nozzle is in a fully open state, in a state in which at least one of a plurality of suction nozzles reaches the vicinity of a component mounting position, and the closing section may be able to guarantee that a radial passage corresponding to the suction nozzle is in a fully closed state, in a state in which at least one of a plurality of suction nozzles reaches the vicinity of a component reception position. In a state in which a plurality of suction nozzles is located at other revolving positions, an opening on a central hole side of a radial passage corresponding to the suction nozzle may be open, and may be closed.

Here, it is further preferable that, in a state in which one of the plurality of suction nozzles is located at the component mounting position, the cutout section of the connection control section sets a plurality of radial passages corresponding to at least the suction nozzle located at the component mounting position and one or more of the suction nozzles located on an upstream side from the suction nozzle located at the component mounting position in a rotation direction of the rotor, to a fully open state. In addition, it is further preferable that, in a state in which one of the plurality of suction nozzles is located at the component reception position, the closing section of the connection control section sets a plurality of radial passages corresponding to at least the suction nozzle located at the component reception position and one or more suction nozzles located on an upstream side from the suction nozzle located at the component reception position in a rotation direction of the rotor, to a fully closed state.

In this way, if a plurality of radial passages corresponding to the suction nozzle located at the component mounting position and one or more suction nozzles located on an upstream side from the suction nozzle located at the component mounting position in a rotation direction of a rotor, is in a fully open state, when switching of a positive pressure control valve is performed in parallel to the approach of an suction nozzle with respect to a component mounting position, supply of positive pressure to an suction nozzle is rapidly performed can be guaranteed.

In addition, if a plurality of radial passages corresponding to the suction nozzle located at a component reception position and one or more suction nozzles located on an upstream side from the suction nozzle located at the component reception position in a rotation direction of a rotor, is in a fully closed state, when switching of a negative pressure control valve is performed in parallel to approaching of an suction nozzle with respect to a component reception position, supply of positive pressure to an suction nozzle can be completely blocked, and supply of negative pressure rapidly performed can be guaranteed.

### Brief Description of Drawings

[Fig. 1] Fig. 1 is a perspective view illustrating a portion of an electronic circuit component mounting line including a plurality of mounting modules serving as an electronic-circuit-component mounting machine that is an embodiment of the present invention.
[Fig. 2] Fig. 2 is a perspective view illustrating a rotary type mounting head and a mounting head moving device of the mounting module.
[Fig. 3] Fig. 3 is a perspective view illustrating the mounting head.
[Fig. 4] Fig. 4 is a perspective view illustrating a component mounting position vicinity section of the mounting head.
[Fig. 5] Fig. 5 is a perspective view illustrating a component reception position vicinity section of the mounting head.
[Fig. 6] Fig. 6 is a side sectional view schematically illustrating the mounting head.
[Fig. 7] Fig. 7 is a diagram illustrating a revolving position of a plurality of suction nozzles of the mounting head.
[Fig. 8] Fig. 8 is a side view illustrating a base plate of a bulk feeder and a component case of the mounting head.
[Fig. 9] Fig. 9 is a side view illustrating the bulk feeder.
[Fig. 10] Fig. 10 is a section plan view illustrating a first radial passage provided in a rotor of the mounting head, and a cutout section of a connection control section provided in a head body.
[Fig. 11] Fig. 11 is a section plan view illustrating a second radial passage provided in the rotor.
[Fig. 12] Fig. 12 is a perspective view illustrating the connection control section.
[Fig. 13] Fig. 13 is a block diagram conceptually illustrating a control device or the like of the mounting module.
[Fig. 14] Fig. 14 is a view illustrating supply of positive pressure that is allowed by the cutout section.

### Description of Embodiments

Hereinafter, embodiments of the present invention will be described with reference to the drawings. The present invention can be implemented in a manner that is subjected to various modifications based on the knowledge of those skilled in the art, in addition to the following embodiments.

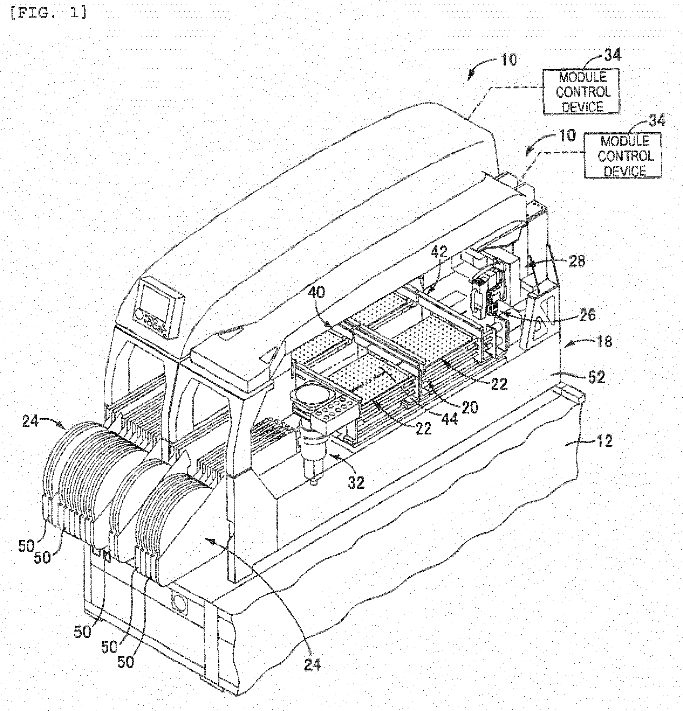

A plurality of mounting modules 10 serving as an electronic-circuit-component mounting machine that is an embodiment of the present invention is illustrated in Fig. 1. The mounting modules 10 are arranged in a row in a manner making them adj acent to each other on a common base which is an integral base 12, are fixed, and configure a mounting line. The mounting module 10 is described in detail, for example, in JP-A-2004-104075, and portions other than the portions related to the present invention will be briefly described. Hereinafter, an electronic circuit component is referred to as a component.

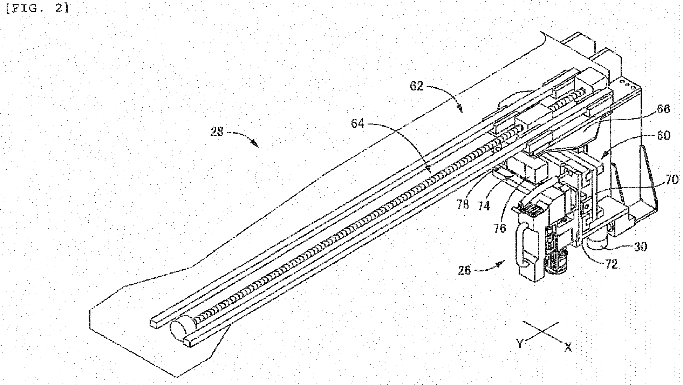

In the present embodiment, each mounting module 10 respectively includes a module body 18 that is a body of a component mounting machine, a circuit board conveyance device 20, a circuit board holding device 22, a component supply device 24, a rotary type mounting head 26 (hereinafter, referred to as a mounting head 26), a mounting head moving device 28, a fiducial mark imaging device 3 0 (refer to Fig. 2), a component imaging device 32, and a module control device 34.

In the present embodiment, the circuit board conveyance device 20 includes two board conveyors 40 and 42, and transports a circuit board 44 (hereinafter, referred to as a board 44) that is a type of a circuit substrate, in a horizontal direction that is parallel to a direction in which the plurality of mounting modules 10 are lined up. In the present embodiment, a "circuit board" will be used as a generic name of a printed wire board and a printed circuit board. The circuit board holding device 22 is provided in each of the two board conveyors 40 and 42 of the module body 18, respectively includes supporting members that support the board 44 from below, and clamp members that respectively clamp both side edges parallel to a transport direction of the board 44, and holds the board 44 in a posture where a component mounting surface on which components of the board 44 are mounted is horizontal. In the present embodiment, a direction in which the board 44 is transported by the circuit board conveyance device 20 is referred to as an X-axis direction, and a direction which is orthogonal to the X-axis direction in a horizontal surface that is a plane parallel to the component mounting surface of the board 44 held on the circuit board holding device 22 is referred to as a Y-axis direction. The component supply device 24 supplies components using a plurality of tape feeders 50 that is an alignment component feeder in the present embodiment, and is provided so as to be fixed to a base plate 52 of the module body 18.

The mounting head moving device 28 includes an X-axis direction moving device 60 and a Y-axis direction moving device 62 as illustrated in Fig. 2. The Y-axis direction moving device 62 includes a linear motor 64 that is provided across a component supply section of the component supply device 24 and the two circuit board holding devices 22, in the module body 18, and moves a Y-axis slide 66 serving as a moving member that is a movable member to an arbitrary position in the Y-axis direction. The X-axis direction moving device 60 is provided in the Y-axis slide 66, moves in the X-axis direction with respect to the Y-axis slide 66, and includes two X-axis slides 70 and 72 serving as moving members that are movable members relatively moving in the X-axis direction, and an X-axis slide moving device 74 (X-axis slide moving device that moves the X-axis slide 72 is illustrated in Fig. 2) that moves the respective X-axis slides 70 and 72 in the X-axis direction.

Two X-axis-slide moving devices include, for example, an electric motor 76 that is a drive source, and a feeding screw mechanism 78 including a screw shaft and a nut, move the X-axis slides 70 and 72 to an arbitrary position in the X-axis direction, and the X-axis slide 72 moves to an arbitrary position in a horizontal movement plane, so as to illustrate the X-axis slide moving device 74. The electric motor 76 is configured by a servo motor with an encoder, in the present embodiment. The servo motor is an electric rotary motor which can perform the correct control of a rotary angle, and instead of the servo motor, a step motor or a linear motor may be used. In addition, a ball screw mechanism is suitable for the feeding screw mechanism. Other electric motors and feeding screw mechanisms which will be described below are the same as above. A head moving device may be assumed that a Y-axis direction moving device is provided on an X-axis slide. The mounting head 26 is detachably mounted on the X-axis slide 72, moves with respect to the circuit board holding device 22 according to the movement of the X-axis slide 72, and moves to an arbitrary position in a head movement area that is a movement area across a component supply section of the component supply device 24 and the two circuit board holding devices 22.

The fiducial mark imaging device 30 is mounted in the X-axis slide 72, is moved together with the mounting head 26 by the mounting head moving device 28, and images a fiducial mark (not illustrated) provided in the board 44, as illustrated in Fig. 2. In addition, the component imaging device 32 is provided so as to fix a position in a portion between the circuit board conveyance device 20 and the component supply device 24 of the base plate 52, as illustrated in Fig. 1, and images a component that is an imaging target from below.

The mounting head 26 will be described. The mounting head 26 is described in detail in the respective specifications of Japanese Patent Application No. 2011-206452 and PCT/JP2012/074105 with regard to application of the present applicant, which are not published yet, and portions other than the portions related to the present invention will be briefly described.

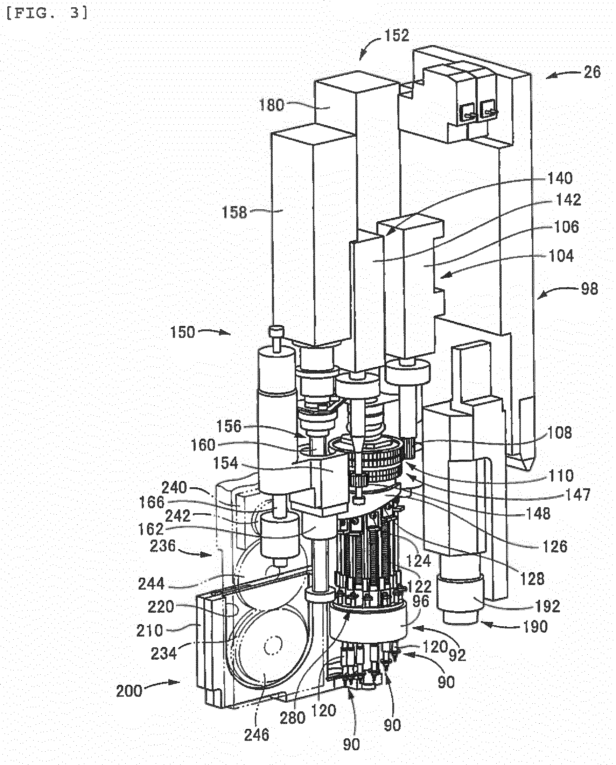

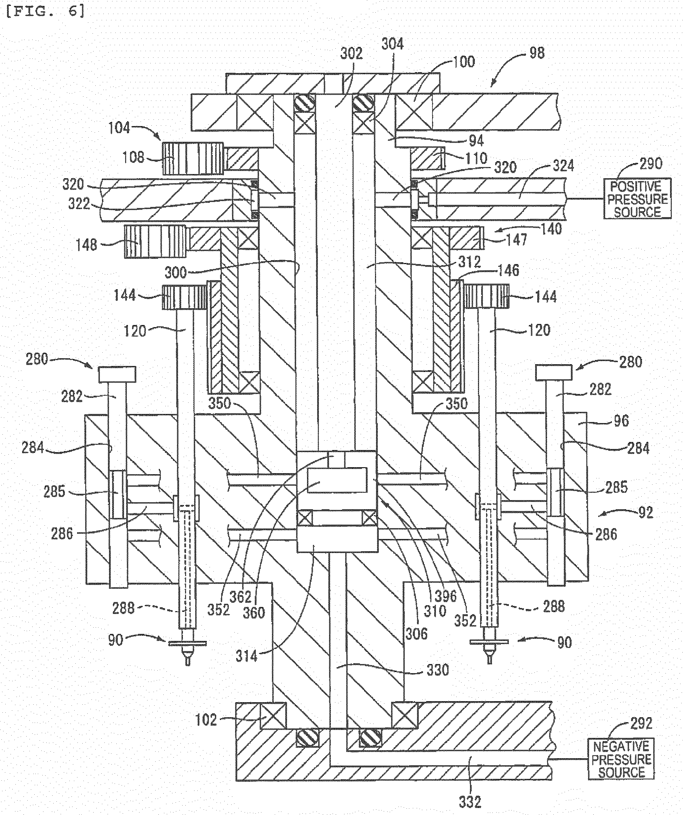

The mounting head 26 includes a plurality of suction nozzles 90, as illustrated in Fig. 3. The plurality of suction nozzles 90 are held by a rotor 92. The rotor 92 includes a shaft section 94 and a nozzle holding portion 96, as schematically illustrated in Fig. 6. Both end portions of the shaft section 94 are rotatably held by a head body 98 via bearings 100 and 102 in a posture in which an axis line of the shaft section 94 is vertical, and the rotor 92 is rotated by a rotor rotation device 104 around a vertical axis line in both forward and reverse directions at an arbitrary angle. The rotor rotation device 104 uses an electric motor 106 (refer to Fig. 3) provided in the head body 98 as a drive source, and rotation of the electric motor 106 is transferred to the rotor 92 by gears 108 and 110.

The nozzle holding portion 96 has a larger diameter than the shaft section 94, a plurality of nozzle holders 120, preferably three or more nozzle holders and twelve nozzle holders in the present embodiment, are provided, and a maximum of twelve of the suction nozzles 90 are held by the rotor 92. Twelve of the nozzle holders 120 are respectively fit so as to move up and down in an axis direction at a plurality of positions separated at appropriate intervals on a circumference around a rotation axis line of the rotor 92 of the outer periphery of the nozzle holding portion 96, at twelve positions with an equal angular interval in the present embodiment, in a posture in which the axis direction is parallel to the rotation axis line of the rotor 92, so as to move upward and downward in the present embodiment, and are rotatably fit around an axis line of the holder. The nozzle holders 120 hold the suction nozzles 90.

The rotor 92 performs intermittent rotation at an angle equal to an arrangement angle interval of the nozzle holder 120, the twelve suction nozzles 90 are revolved around the rotation axis line of the rotor 92, and sequentially stop at each of twelve revolving positions that are set so as to be separated at an equal angle. In addition, as illustrated in Fig. 3, the nozzle holders 120 are pressed upward by a compression coil spring 122, and a roller 124 that is a cam follower which is provided on an upper portion of the nozzle holder 120 moves along a cam surface 128 of a cam 126 that is provided in the head body 98 so as to be fixed. Thereby, the suction nozzles 90 are revolved around the rotation axis line of the rotor 92 and are lifted.

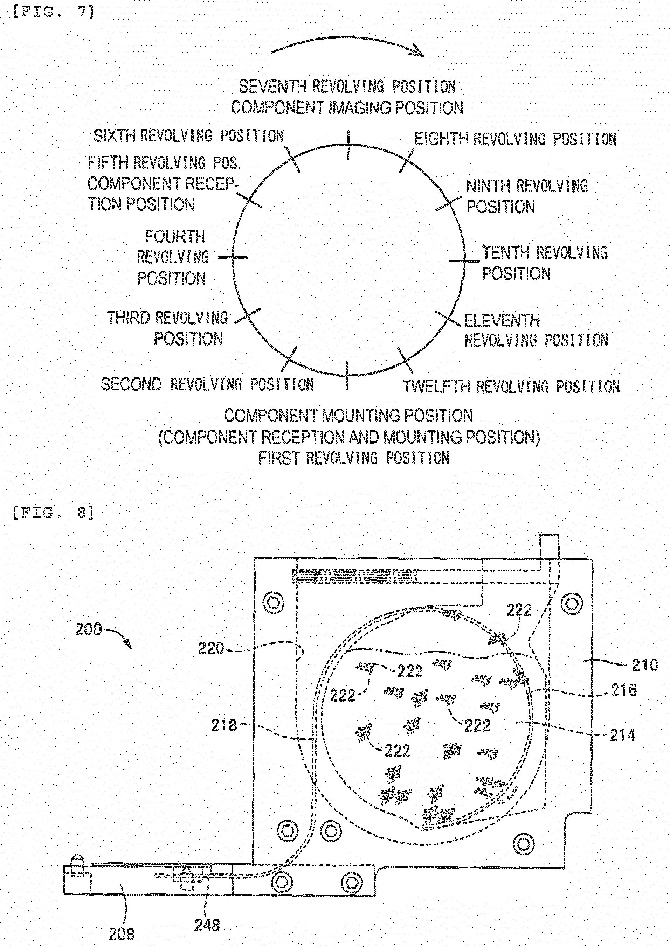

For this reason, all distances in a height direction from the circuit board holding device 22 of the suction nozzles 90 at twelve revolving positions to a stop position are not equal, a revolving position with the shortest distance in a height direction becomes a component mounting position in which mounting of a component to the board 44 is performed, and a position that is separated by 180 degrees from the component mounting position, in the most long and high revolving position becomes a component imaging position. In addition, as illustrated in Fig. 7, if the component mounting position is set to a first revolving position, a fifth revolving position that is a fifth revolving position in a rotation direction (direction illustrated by a solid line in Fig. 7) of the rotor 92 at the time of mounting of component to the board 44, becomes a component reception position in which a component is received from a bulk feeder that will be described later. Out-take of a component from the tape feeder 50 by the suction nozzles 90, and mounting to the board 44 of a component that is taken out from the tape feeder 50 and a bulk feeder are all performed at a component mounting position, and the component mounting position is also a component reception and mounting position. In Fig. 6, the spring 122, the roller 124, and the cam 126 are not illustrated. Alternatively, the compression coil spring 122 is a type of spring which is used as an elastic member that is a type of lifting device. Other coil springs that will be described below are also the same as above.

In addition, as illustrated in Fig. 3, a nozzle rotation drive device 140 is provided in the head body 98, the nozzle holders 120 are rotated around an axis line of the nozzle holder s120, and the suction nozzles 90 rotate. The nozzle rotation drive device 140 uses an electric motor 142 as a drive source. As illustrated in Fig. 6, rotation of the electric motor 142 is transferred to the twelve nozzle holders 120 by a gear 144 attached to each of the twelve nozzle holders 120 and gears 146, 147, and 148 common to the twelve nozzle holders 120, and all twelve of the suction nozzles 90 rotate at the same time.

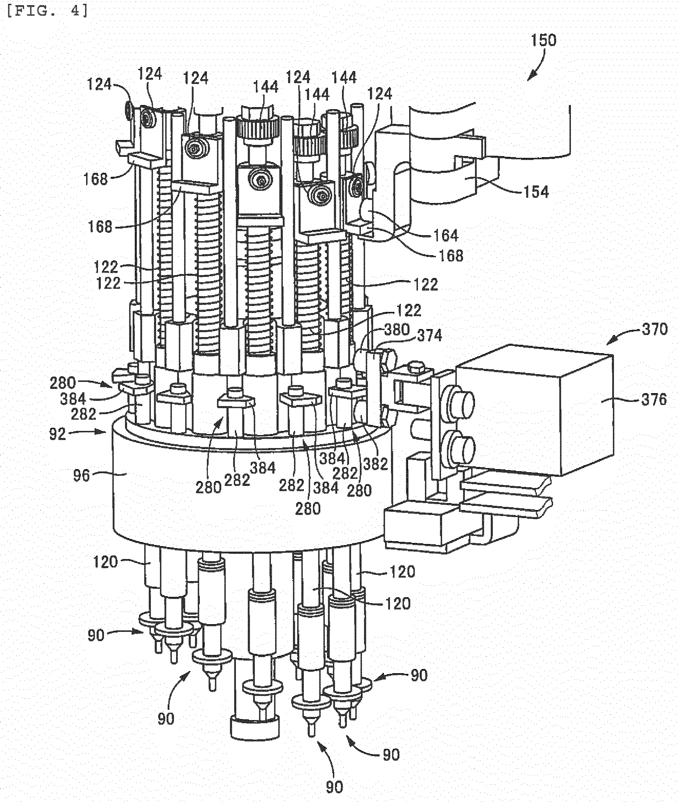

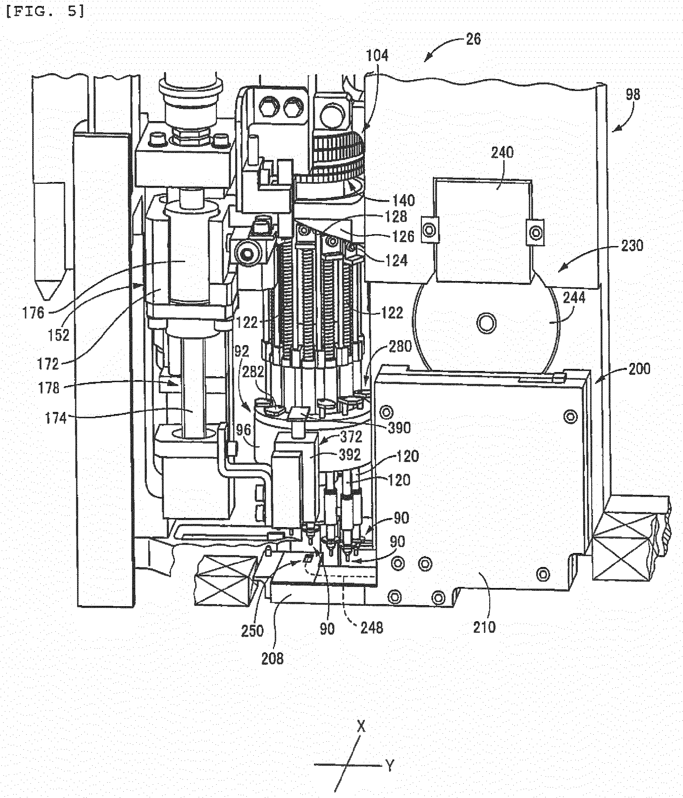

As illustrated in Fig. 3 and Fig. 5, nozzle lifting devices 150 and 152 that are nozzle advancing and retreating devices are respectively provided in a portion corresponding to a component mounting position and a component reception position of the head body 98. The nozzle lifting device 150 at the component mounting position includes a lifting and lowering member 154, a feeding screw mechanism 156, and an electric motor 158, as illustrated in Fig. 3. The feeding screw mechanism 156 includes a feeding screw 160 and a nut 162. The lifting and lowering member 154 is fixed to the nut 162, as illustrated in Fig. 4, a roller 164 that is a rotation engaging member on the rotor 92 side of the lifting and lowering member 154 is attached to be rotatable around an axis line orthogonal to a rotation axis line of the rotor 92, and configures an engaging unit. The feeding screw 160 is rotated by the electric motor 158, and thereby the lifting and lowering member 154 is guided to a guide rod 166 (refer to Fig. 3) configuring a guiding device, and moves to an arbitrary position in a vertical direction.

In accordance with the descent of the lifting and lowering member 154, the roller 164 is in contact with an upper surface of an engaged section 168 (refer to Fig. 4) of a plate shape provided in the nozzle holder 120, presses down the nozzle holder 120 against a pressing force of the compression coil spring 122, and allows the suction nozzles 90 to descend. By the ascent of the lifting and lowering member 154, the nozzle holders 120 are allowed to ascend by a pressing force of the compression coil spring 122, and the suction nozzles 90 ascend. The nozzle lifting device 150 is a device having a configuration in which the suction nozzles 90 forcibly descend, and allows to ascend.

The nozzle lifting device 152 in a component reception position is configured in the same manner as the nozzle lifting device 150, and as illustrated in Fig. 5, includes a lifting and lowering member 172, a feeding screw mechanism 178 including a feeding screw 174 and a nut 176, and an electric motor 180 (refer to Fig. 3). A roller (not illustrated) is rotatably attached to the lifting and lowering member 172, and thereby configures an engaging unit. The nozzle lifting device may be configured by a device that forcibly moves the suction nozzles 90 together in ascending and descending motion.

As illustrated in Fig. 3, a component imaging device 190 is provided in a component imaging position. A camera 192 of the component imaging device 190 images a component taken out from the tape feeder 50 or the following bulk feeder by the suction nozzle 90, via a reflection device (not illustrated) .

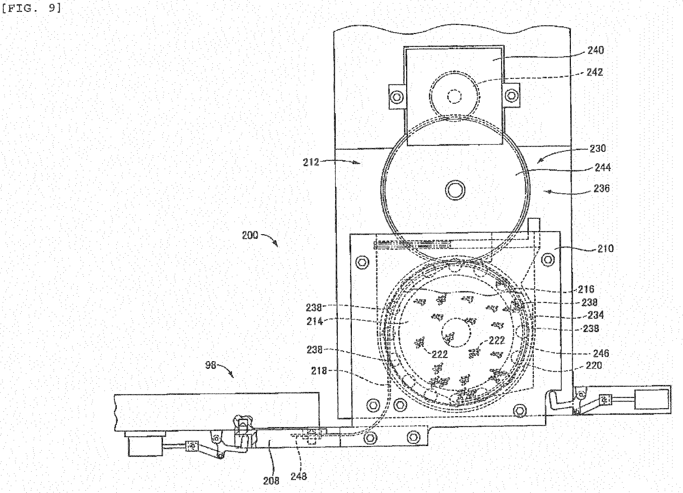

As illustrated in Fig. 5, a bulk feeder 200 that is a type of a component feeder is provided in a portion corresponding to the component reception position of the head body 98, and moves together with the suction nozzle 90 or the like by the mounting head moving device 28. The component supply device 24 is a mounting machine body side component supply device that is provided in a fixed manner on the base plate 52 of the module body 18, the tape feeder 50 that configures the component supply device 24 is a mounting machine body side feeder, the bulk feeder 200 is a head side feeder provided in the mounting head 26, and these devices configure the component supply device of the mounting module 10. As illustrated in Fig. 8 and Fig. 9, the bulk feeder 200 includes a base plate 208, a component case 210, and a component feeding device 212. A storage chamber 214, a guide groove 216, a guide passage 218, and a recessed portion 220 are provided in the component case 210. A plurality of components 222 are contained in the storage chamber 214 as bulk components in a bulk carrier state. A leadless electronic circuit component having no lead, for example, a component (chip component) having an electrode formed of a magnetic material such as a capacitor or a resistor, is contained as the component 222.

The component feeding device 212 includes a bulk component drive device 230 illustrated in Fig. 9. The bulk component drive device 230 is provided in the head body 98, and includes a turntable 234 and a turntable drive device 236. The turntable 234 is accommodated in the recessed portion 220 of the component case 210, and a plurality of permanent magnets 238, for example, three or more permanent magnets are held on a side surface of the turntable 234. The turntable drive device 236 uses an electric motor 240 as a drive source, rotation of the turntable drive device 236 is transferred to the turntable 234 by gears 242, 244, and 246, and the turntable drive device 236 rotates the turntable 234 in both forward and reverse directions in an arbitrary angle. Thereby, the components 222 in the storage chamber 214 are sucked by the permanent magnets 238 thereby moving from below to above, a portion is introduced into the guide groove 216, enters the guide passage 218 from the guide groove 216, and moves in a state of being aligned in a row. The components 222 eventually enter a guide passage 248 (refer to Fig. 5) provided on the base plate 208, and move to a component supply section 250 (refer to Fig. 5). The guide passage 248 extends out from the component case 210 to a position located on a lower side of the suction nozzle 90 located at a component reception position, and this portion configures the component supply section 250. Air in the guide passage 248 is sucked by an air suction device (not illustrated), and movement to the component supply section 250 of the components 222 is promoted. Movement of the components 222 is stopped by a stopper (not illustrated) provided on the base plate 208, and a head component 222 is positioned in the component supply section 250. In the present embodiment, the component case 210 configures a component accommodation section, the guide groove 216, the guide passages 218 and 248, the bulk component drive device 230, and the air suction device configure the component feeding device 212, and configure a component feeding section that aligns the components in the component accommodation section in the guide passage in a row and feeds to the component supply section.

As illustrated in Fig. 4, control valve devices 280 corresponding to each of the twelve nozzle holders 120 are provided in the nozzle holding portion 96 of the rotor 92, and control the supply of positive pressure and negative pressure to the suction nozzles 90. In the present embodiment, the control valve device 280 is configured by a spool valve, and a valve spool 282 is movably introduced into a spool hole 284 formed in the nozzle holding portion 96 in a direction parallel to the rotation axis line of the rotor 92, as schematically illustrated in Fig. 6. A switching section 285 with a small diameter of the valve spool 282 connects with the suction nozzle 90 by a passage 286 formed in the nozzle holding portion 96, and a passage 288 formed in the nozzle holder 120. As illustrated in Fig. 6, it is assumed that the present control valve device 280 enters a positive pressure source connection blocking state in which connection with a positive pressure source 290 of the suction nozzle 90 is blocked, and a negative pressure source connectable state in which the suction nozzle 90 is connectable with a negative pressure source 292, from a positive pressure source connectable state in which the suction nozzle 90 is connectable with the positive pressure source 290, and a negative pressure source connection blocking state in which connection with the negative pressure source 292 of the suction nozzle 90 is blocked, according to the valve spool 282 that descends, and enters reverse states according to the valve spool 282 that ascends. The control valve device 280 configures a negative pressure control valve and a positive pressure control valve, and the negative pressure control valve and the positive pressure control valve are integrally formed in the present embodiment. Alternatively, the negative pressure control valve and the positive pressure control valve may be provided separately.

As illustrated in Fig. 6, a central hole 300 that uses an axis line as a center line is formed in the rotor 92. An end of the central hole 300 is opened in an upper surface of the shaft section 94, the other end of the central hole 300 is formed by a bottomed via hole leading to the inside of the nozzle holding portion 96, and a supporting shaft 302 is concentrically disposed inside the central hole 300. An upper end of the supporting shaft 302 is fixed to the head body 98, bearings 304 and 306 are provided between both of the upper and lower ends and the rotor 92, and although the supporting shaft 302 and the rotor 92 are supported to each other, the supporting shaft 302 does not rotate regardless of the rotation of the rotor 92.

A diameter of the supporting shaft 302 is smaller than a diameter of the central hole 300, but a connection control section 310 with a diameter that is introduced exactly, relatively, and rotatably to the central hole 300 is integrally provided in a portion adjacent to an upper side of a portion in which the bearing 306 is provided, in the lower end portion of the supporting shaft 302. Thereby, in the inside of the central hole 300, an annular passage 312 is formed on an upper side of the connection control section 310, and on a lower side of the connection control section 310, a connection chamber 314 is formed between the supporting shaft 302 and a bottom face of the central hole 300. The passage 312 connects with the positive pressure source 290 by a port 320 formed in the shaft section 94, an annular passage 322 provided in the head body 98, a passage 324 connected in the passage 322, or the like. In addition, the connection chamber 314 connects with the negative pressure source 292 by a passage 330 formed in the bearing 94, and a passage 332 formed in the head body 98.

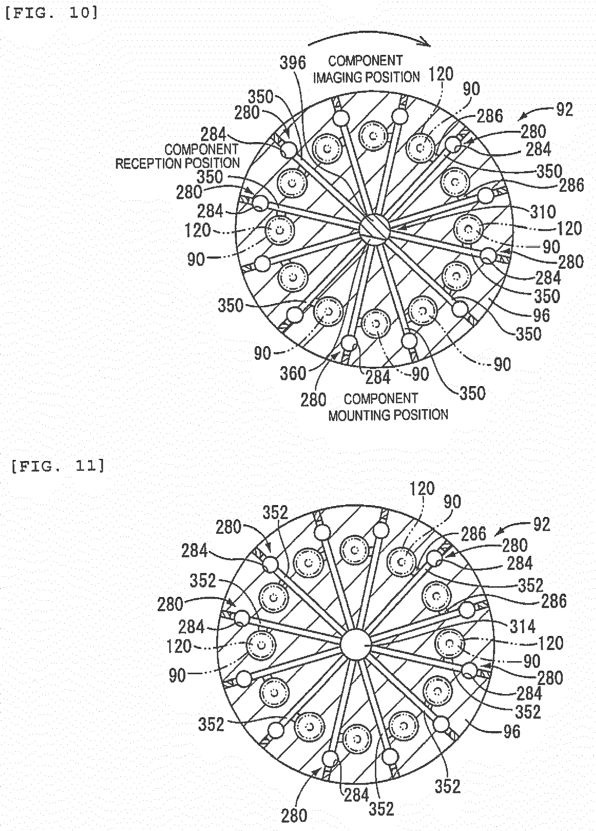

As illustrated in Fig. 6, in a portion corresponding to the connection control section 310 of the nozzle holding portion 96, a plurality of radial passages 350, which are twelve radial passages 350 as illustrated in Fig. 10 in the present embodiment, is formed in a state of extending out in a radial shape from the central hole 300, and configures a first radial passage. Hereinafter, the radial passages 350 are referred to as first radial passages 350. Each sectional shape of the twelve first radial passages 350 has a circular shape, each of the twelve first radial passages 350 is orthogonal to each of the twelve spool holes 284, and extends out in an equal angular interval at twelve positions corresponding to each of the twelve suction nozzles 90. The control valve devices 280 provided in the corresponding suction nozzles 90 enter a positive pressure source connectable state, and thereby the twelve first radial passages 350 are respectively connected to the suction nozzles 90 via the switching section 285, and the passages 286 and 288.

In addition, in the nozzle holding portion 96, a plurality of radial passages 352, which are twelve radial passages as illustrated in Fig. 11 in the present embodiment, is formed in a state of extending outward in a radial manner from the connection chamber 314 as illustrated in Fig. 6, and the radial passages 352 configure a second radial passage. Hereinafter, the radial passages 352 are referred to as the second radial passages 352. Each sectional shape of the twelve second radial passages 352 has a circular shape, each of the twelve second radial passages 352 is located on a side lower than the first radial passage 350, is formed in a portion separated in a parallel direction to the rotation axis line of the rotor 92, is orthogonal to each of the twelve spool holes 284, and extends outward in an equal angular interval at positions corresponding to each of the twelve suction nozzles 90 from a central portion of the rotor 92. The twelve second radial passages 352 are connected to the negative pressure source 292 via the connection chamber 314 regardless of the rotational position of the rotor 92. In the present embodiment, the connection chamber 314 and the passage 330 configure a negative pressure source connection passage. The control valve devices 280 provided in the corresponding suction nozzles 90 enter a negative pressure source connectable state, and thereby the twelve second radial passages 352 are respectively connected to the suction nozzles 90 via the switching section 285, and the passages 286 and 288.

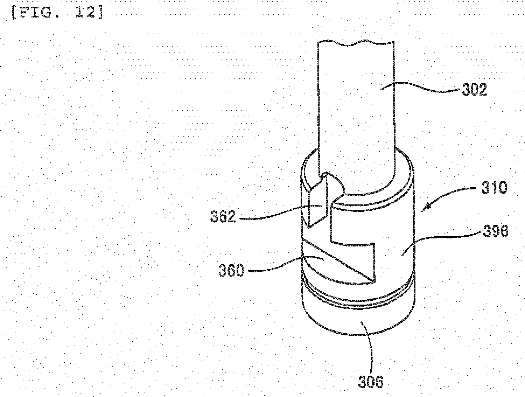

As illustrated in Fig. 12, in a portion in an axis direction of the outer circumference of the connection control section 310, a portion of the portions corresponding to the portions in which the first radial passages 350 of the nozzle holding portion 96 in an axis direction are formed does not include the axis line of the supporting shaft 302, is cut in a plane parallel to the axis line of the supporting shaft 302, and a cutout section 360 in which a sectional shape of an opening of an outer circumferential surface of the connection control section 310 is an arch is formed. A dimension of the cutout section 360 in a direction parallel to the axis direction of the connection control section 310 is greater than a diameter of the first radial passage 350. The cutout section 360 connects with the passage 312 (refer to Fig. 6) by a passage 362 formed in a portion in which the cutout section 360 of the connection control section 310 is defined. Thereby, the cutout section 360 connects with the positive pressure source 290 by the passage 312, the port 320, and the passages 322 and 324. The passage 312 has an annular shape, and the cutout section 360 connects with the positive pressure source 290, regardless of the rotational position of the rotor 92. In the present embodiment, the passage 312 configures a positive pressure source connection passage. The positive pressure source connection passage and the negative pressure source connection passage configured by the connection chamber 314 and the passage 330 extend in directions opposite to each other and parallel to the rotation axis line of the rotor 92, from positions in which the first radial passage 350 and the second radial passage 352 are respectively connected. In the present embodiment, the positive pressure source connection passage extends upwards, and the negative pressure source connection passage extends downwards. For this reason, it is possible to configure a rotor with a small diameter, compared to a case in which the two connection passages are provided side by side in a direction orthogonal to the rotation axis line of the rotor. In addition, it is possible to make a connection between the positive pressure source connection passage and the positive pressure source 290, and a connection between the negative pressure source connection passage and the negative pressure source 292, at positions different from each other. It is possible to avoid complicating the configuration of the mounting head 26.

The rotor 92 rotates around the connection control section 310 that is provided in the supporting shaft 302 and is fixed to the head body 98, and the twelve first radial passages 350 rotate with the cutout section 360. For this reason, among the twelve first radial passages 350, only the first radial passage 350 that is in a state of being located at a position corresponding to the cutout section 360 connects with the cutout section 360, and the first radial passage 350 deviated from the cutout section 360 is not connected to the cutout section 360. In the present embodiment, as illustrated in Fig. 10, the cutout section 360 is formed as a cutout having an arch sectional shape defined by a chord and a circumference which correspond to a central angle of 120 degrees of the rotor 92. For this reason, an opening on a center side of the rotor 92 of the first radial passage 350 can face entirely the cutout section 360, one first radial passage 350 corresponding to the suction nozzle 90 at a component mounting position and the first radial passages 350 on both sides of the one first radial passage 350 enter a fully open state, in a state in which the rotor 92 stops rotation at a position illustrated in Fig. 10, and furthermore, openings on center sides of the rotors of the first radial passages 350 located further on the both sides thereof enter a state of being half closed by the connection control section 310.

The above description that is "one first radial passage 350 corresponding to the suction nozzle 90 at a component mounting position and the first radial passages 350 on both sides of the one first radial passage 350 enter a fully open state" does not mean that an opening on the center side of the rotor of the first radial passages 350 simply enters a fully open state. For example, if the rotor 92 rotates in a small angle from a position illustrated in Fig. 10, in the first radial passage 350 in which an opening on the center side of the rotor is in a half-open state in Fig. 10, an opening on the center side of the rotor exactly enters a fully open state. However, in this state, a partial cylindrical surface (a portion of the cylindrical surface) defining an opening edge of the rotor and a bottom face (includes the chord and a plane parallel to the center line of the rotor 92) of the cutout section 360 facing the partial cylindrical surface are adjacent to each other, and an angle forming the both surfaces is small. Thus, the flow of air flowing from the cutout section 360 to the first radial passage 350 enters a state of being throttled. In this state, the first radial passage 350 is not in a state of being fully open, and as illustrated in Fig. 10, in the same manner as one first radial passage 350 corresponding to the suction nozzle 90 at a component mounting position and the first radial passages 350 on both sides of the one first radial passage 350, the partial cylindrical surface defining the opening edge of the opening on the center side of the rotor of the first radial passages 350 is sufficiently separated from the bottom face of the cutout section 360. In a case in which the flow of the air flowing from the cutout section 360 to the first radial passages 350 in a state of not being throttled, it is said that the first radial passages 350 is in a fully open state.

Alternatively, from the viewpoint of a formation purpose of the cutout section 360, it is preferable that, in a state in which one of the plurality of suction nozzles 90 is located at a component mounting position, the cutout section 360 is provided in a state in which the plurality of first radial passages 350 corresponding to at least the suction nozzle 90 located at the component mounting position and one or more suction nozzles 90 located on an upstream side from the suction nozzle 90 located at the component mounting position in a rotation direction of the rotor 92 are in a fully open state. It is natural that the first radial passage 350 corresponding to the suction nozzle 90 at a component mounting position has to be in a fully open state, as a formation purpose of the cutout section 360. However, it is preferable that the first radial passages 350 corresponding to the one or more suction nozzles 90 located on an upstream side from the suction nozzle 90 located at the component mounting position in the rotation direction of the rotor 92 are also in a fully open state, because it is preferable that, regardless of a rotation speed of the rotor 92, during a time period in which the control valve device 280 is in a positive pressure source connectable state, positive pressure is supplied to the first radial passage 350 by more sufficient pressure.

In addition, since a section in which the cutout section 360 of the connection control section 310 is not formed is a section which causes the first radial passage 350 to be in a closed state, the section is assumed to be referred to as a closing section 396. However, if viewing from a formation purpose of the closing section 396 as well, it is natural that, in a state in which the rotor 92 is stopped, the first radial passage 350 corresponding to one suction nozzle 90 located at a component reception position has to be in a fully closed state. However, it is preferable that one or more first radial passages 350 corresponding to one or more suction nozzles 90 located on an upstream side from the suction nozzle 90 located at the component reception position in the rotation direction of the rotor 92 are also in a fully closed state. The reason is that it is preferable that, regardless of a rotation speed of the rotor 92, during a time period in which the control valve device 280 is in a negative pressure source connectable state, the inside of the suction nozzle 90 is entirely in atmospheric pressure, and as soon as the control valve device 280 is in a negative pressure source connectable state, the inside of the suction nozzle 90 has sufficient negative pressure.

The cutout section 360 and the closing section 396 may be provided in a state of satisfying the above-described condition, and there is no problem in that an opening on a center side of the rotor of the first radial passage 350 other than those described above is in one of an open state and a closed state. Alternatively, in the present embodiment, as described above, from a viewpoint in which the cutout section 360 is easily formed by machining, in a state in which the rotor 92 stops rotation at a position illustrated in Fig. 10, in such a manner that one first radial passage 350 corresponding to the suction nozzle 90 at a component mounting position and the first radial passages 350 on both sides of the one first radial passage 350 enter a fully open state, the cutout section 360 has an arch sectional shape defined by a chord and a circumference which correspond to a central angle of 120 degrees of the rotor 92, and the closing section 396 causes that one first radial passage 350 corresponding to the suction nozzle 90 at a component reception position, another first radial passage 350 adjacent to an upstream side in a rotation direction of the rotor 92 of the one first radial passage 350, and the first radial passages 350 corresponding to the suction nozzles 90 that are respectively stopped at five revolving positions from a sixth revolving position to a tenth revolving position, are in a fully closed state. Thus, if a formation state of the first radial passage 350 in the rotor 92 is changed, a formation state of the cutout section 360 also has to be changed.

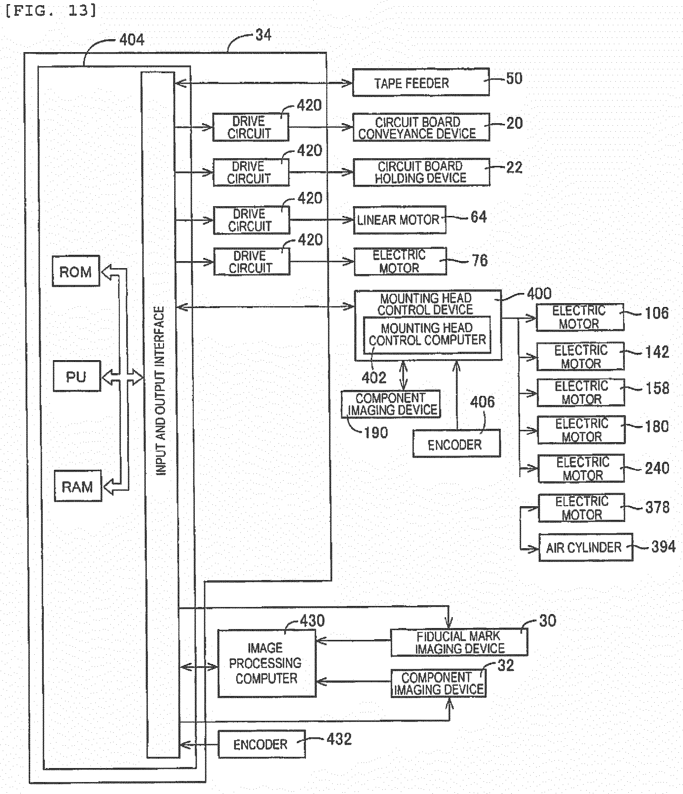

Valve switching devices 370 and 372 are respectively provided in portions corresponding to the component mounting position and the component reception position of the head body 98. As illustrated in Fig. 4, the valve switching device 370 provided in the component mounting position includes a switching member 374 and a switching member drive device 376. The switching member drive device 376 uses an electric motor 378 (refer to Fig. 13) as a drive source, and rotates the switching member 374 in both forward and reverse directions around an axis line orthogonal to a rotation axis line of the rotor 92. Thereby, two engaging sections 380 and 382 that are configured by rollers of the switching member 374 are selectively engaged with an engaged section 384 of a plate shape of the valve spool 282, makes the valve spool 282 descend or ascend with respect to the nozzle holding portion 96. As illustrated in Fig. 5, the valve switching device 372 provided at a component reception position includes a switching member 390 and a switching member drive device 392. The switching member drive device 392 includes an air cylinder 394 (refer to Fig. 13) that is a type of fluid pressure actuator, and makes the switching member 390 ascend or descend. A roller (not illustrated) is attached to the switching member 390 so as to be able to rotate around an axis line orthogonal to a rotation axis line of the rotor 92 thereby configuring an engaging section, is engaged with the upper surface of the engaged section 384, and presses down the valve spool 282.

Furthermore, a mounting head control device 400 (refer to Fig. 13) is provided in the head body 98. The mounting head control device 400 is configured by using a mounting head control computer 402 as a main body. The mounting head control device 400 is connected to a module control computer 404 forming a main body of the module control device 34, and configures a component mounting control device together with the module control device 34. The mounting head control device 400 controls the electric motor 106 or the like configured by a servo motor with an encoder. Each encoder 406 such as the electric motor 106 is connected to the mounting head control computer 402 so as to representatively show one.

As illustrated in Fig. 13, the module control device 34 controls drive sources or the like of various devices configuring the mounting modules 10 such as the linear motor 64 via a drive circuit 420. An input and output interface of the module control computer 404 is connected to an image processing computer 430 that processes data obtained by imaging of the fiducial mark imaging device 30 and the component imaging device 32, an encoder 432 (one is representatively illustrated in Fig. 13) provided in the electric motor 76 or the like of the X-axis slide moving device 74, the mounting head control computer 402, or the like. Alternatively, imaging data of the component imaging device 190 of the mounting head 26 is transferred to the image processing computer 430 and is processed by the image processing computer 430, and necessary data is transferred to the mounting head control computer 402. Furthermore, a RAM of the module control computer 404 stores various programs and data for components mounted on the board 44.

In the mounting module 10 configured as described above, an operation is performed in which the suction nozzle 90 takes out the components 222 from the bulk feeder 200 and mounts the components on one board 44, as one aspect of mounting components to the board 44. The twelve suction nozzles 90 are sequentially revolved to the component reception position by the rotation of the rotor 92, after receiving the components 222 from the bulk feeder 200, the components are imaged by the component imaging device 190 at a component imaging position, and the suction nozzles 90 are revolved to the component mounting position thereby mounting the components 222 on the board 44. At the time of mounting, a holding position error of the component 222 caused by the suction nozzle 90 and a position error of a component mounting point of the board 44 that is obtained by imaging of a fiducial mark, are corrected. The bulk feeder 200 moves together with the suction nozzles 90 and supplies the components 222, the mounting head 26 is moved with respect to the circuit board holding device 22, the twelve suction nozzles 90 are sequentially moved to the respective revolving positions by rotation of the rotor 92, and reception of the components 222, imaging, and mounting are performed in parallel.

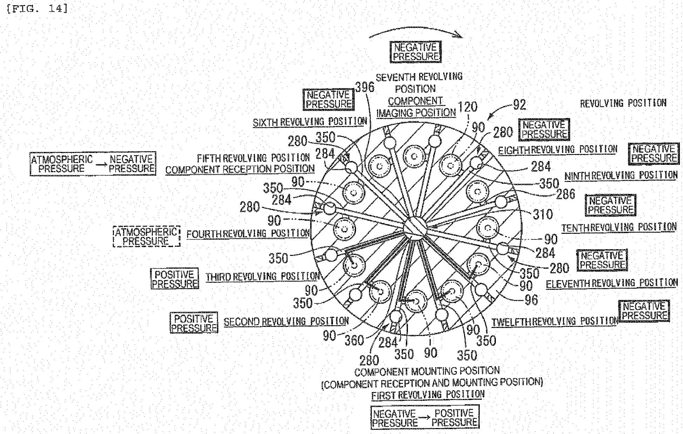

When the suction nozzle 90 on which the component 222 is suctioned is revolved to the component mounting position, the control valve device 280 corresponding to the suction nozzle 90 enters a negative pressure source connectable state, and negative pressure is supplied to the suction nozzle 90 as illustrated in Fig. 14. If the suction nozzle 90 reaches an eleventh revolving position, the first radial passage 350 corresponding to the suction nozzle 90 enters a half-opened state by the cutout section 360, and connection between the suction nozzle 90 and the positive pressure source 290 is started as illustrated by a thick black line in Fig. 14. However, since the control valve device 280 corresponding to the suction nozzle 90 is in a negative pressure source connectable state, positive pressure is not supplied to the suction nozzle 90, and the suction nozzle 90 is maintained in a state of holding the component 222. The first radial passage 350 corresponding to the suction nozzle 90 that is stopped at a twelfth revolving position enters a fully open state, and the first radial passage 350 is in a state in which the positive pressure is sufficiently supplied, but the control valve device 280 corresponding to the suction nozzle 90 is in a negative pressure source connectable state, and thus, positive pressure is also not supplied to the suction nozzle 90.

As illustrated in Fig. 4, the engaged section 168 of the nozzle holder 120 is elongated in a revolving direction of the suction nozzle 90, before the suction nozzle 90 reaches the component mounting position, the lifting and lowering member 154 of the nozzle lifting device 150 descends thereby being engaged with the engaged section 168, and the suction nozzle 90 descends while revolving. The lifting and lowering member 154 is engaged with the engaged section 168 in the roller 164, and allows the revolving of the suction nozzle 90 by rotation of the roller 164. The valve switching device 370 operates while lowering of the suction nozzle 90, the switching member 374 presses up the valve spool 282, and switches the control valve device 280 from a negative pressure source connectable state to a positive pressure source connectable state. Thereby, the suction nozzle 90 is cut out from the negative pressure source 292 and connects with the positive pressure source 290, a negative pressure is positively extinguished by the supply of a positive pressure, and the component 222 is rapidly released thereby being mounted on the board 44. The first radial passage 350 corresponding to the suction nozzle 90 starts to connect with the cutout section 360, from the suction nozzle 90 that reaches the eleventh revolving position on two upstream sides in a rotation direction of the rotor from the component mounting position, the first radial passage 350 is in a fully open state at the time of reaching the twelfth revolving position, the internal pressure of the first radial passage 350 has a sufficient positive pressure when the suction nozzle 90 reaches the component mounting position, the cutout section 360 can connect simultaneously with a plurality of first radial passages 350 and the positive pressure source 290, and in addition, formation is easily performed by machining as described above. As is apparent from the above description, the cutout section 360 is formed in a state in which three first radial passages 350 corresponding to the suction nozzles 90 that are stopped at three revolving positions around the component mounting position are in a fully open state, and in the present embodiment, an angle area slightly wider than a stop position of the three first radial passages 350 becomes a first setting angle area in which the first radial passage 350 is in a fully open state.

The engaged section 384 of the valve spool 282 is elongated in a revolving direction of the valve spool 282. In addition, the switching member 374 is engaged with the valve spool 282 in the roller, and the valve spool 282 can be revolved together with the suction nozzle 90 and can be pushed up by engagement with the engaged section 384 of the roller and rotation of the roller. After component mounting, the suction nozzle 90 ascends, revolves, and moves to the component reception position. Even in this case, ascending and revolving of the suction nozzle 90 are performed in parallel. After the valve control device 280 is switched, the switching member 374 is then returned to a position in which switching of the control valve device 280 corresponding to the suction nozzle 90 that reaches the component mounting position is performed. Then, when the suction nozzle 90 revolves from a third revolving position to a fourth revolving position, the first radial passage 350 corresponding to the suction nozzle 90 deviates from the cutout section 360, as illustrated in Fig. 14, and connection with the positive pressure source 290 is cut out. Thereby, the control valve device 280 is in a positive pressure source connectable state, but connection between the suction nozzle 90 and the positive pressure source 290 is blocked, an internal pressure of the suction nozzle 90 is decreased, and eventually becomes atmospheric pressure.

In the same manner as at the time of component mounting, the suction nozzle 90 descends while being revolved from the fourth revolving position to the component reception position, and the control valve device 280 is switched from a positive pressure source connectable state to a negative pressure source connectable state by the valve switching device 372, in parallel to the descending. It is because the switching member 390 presses down the valve spool 282. After the suction nozzle 90 is stopped at the third revolving position, connection with the positive pressure source 290 is cut off, internal pressure is decreased to atmospheric pressure, and thereby while the control valve device 280 is switched to a negative pressure source connectable state, compressed air is blown from the suction nozzle 90, and the component 222 that is supplied by the bulk feeder 200 is not blown away. If the suction nozzle 90 passes through the revolving position on the two upstream sides in the rotation direction of the rotor from the component reception position, connection with the positive pressure source 290 of the suction nozzle 90 is cut off, and the internal pressure of the suction nozzle 90 is sufficiently decreased until switching of the control valve device 280 is performed at the component reception position. That is, in the present embodiment, one first radial passage 350 corresponding to the suction nozzle 90 that is stopped at the component reception position, and another first radial passage 350 corresponding to the suction nozzle 90 that is stopped at the fourth revolving position on an upstream side from the suction nozzle 90 located at the component reception position in a rotation direction of the rotor, are in a fully closed state by the closing section 396. As is apparent from Fig. 14, the first radial passages 350 corresponding to the suction nozzles 90 that are stopped up to the tenth revolving position are in a fully closed state, and an angle area slightly wider than an interval between the first radial passages 350 corresponding to the suction nozzles 90 that are respectively stopped at the fourth revolving position and the tenth revolving position is made to a second setting angle area in which the first radial passages 350 are in a fully closed state.

As is apparent from the above description, in the present embodiment, the supporting shaft 302 and the head body 98 configure a non-rotation section, and the connection control section 310 and the passage 312 configure a nozzle and positive pressure source connecting and blocking section.

By switching of the control valve device 280 from a positive pressure source connectable state to a negative pressure source connectable state, the suction nozzle 90 connects with the negative pressure source 292 thereby negative pressure is supplied, and the component 222 is picked up. The suction nozzle 90 is revolved in parallel to ascending, takes out the component 222 from the bulk feeder 200, and moves to a next revolving position. The lifting and lowering member 172 of the nozzle lifting device 152 is engaged with the engaged section 168 of the nozzle holders 120 in the roller, and allows revolving of the suction nozzle 90 by rotation of the roller. In addition, the switching member 390 of the valve switching device 372 is engaged with the valve spool 282 by the roller, the valve spool 282 can be revolved together with the suction nozzle 90 by rotation of the roller, and can be pressed down. After switching of the control valve device 280, the switching member 390 is then returned to a position in which switching of the control valve device 280 corresponding to the suction nozzle 90 that subsequently reaches the component reception position is performed.

In this way, in the present mounting modules 10, receiving and mounting of the component 222 are performed in parallel, switching of the control valve device 280 is performed in parallel to descending of the suction nozzle 90, and a high efficiency of mounting is obtained. In addition, even if revolving and lifting of the suction nozzle 90 in the vicinity of the component reception position are performed in parallel, mounting efficiency is improved. In the present mounting head 26, the valve switching device 372 that performs switching of the control valve device 280 at the time of receiving the component is provided in a portion corresponding to the component reception position of the head body 98, and in a case in which revolving and lifting of the suction nozzle 90 are performed in parallel, switching of the control valve device 280 is performed at the time of approaching the bulk feeder 200 of the suction nozzle 90. There is no risk that the component 222 is blown away, and thereby while the suction nozzle 90 revolves and approaches the bulk feeder 200, switching of the control valve device 280 can be performed, time required for receiving the component can be reduced, and mounting efficiency can be further improved. In addition, revolving and lifting of the suction nozzle 90 are performed in parallel in the vicinity of the component mounting position, and thereby mounting efficiency is improved.

### Reference Signs List

26: rotary type mounting head, 28: mounting head moving device, 34: module control device, 90: suction nozzle, 92: rotor, 98: head body, 104: rotor rotation device, 150, 152: nozzle lifting device, 200: bulk feeder, 280: control valve device, 300: central hole, 302: supporting shaft, 310: connection control section, 350: first radial passage, 352: second radial passage, 360: cutout section, 396: closing section

## Claims

1. An electronic-circuit-component mounting machine (10) comprising:
a circuit substrate holding device (22) that holds a circuit substrate (44);
a component supply device (24) that supplies an electronic circuit component;
a positive pressure source (290) that supplies positive pressure;
a negative pressure source (292) that supplies negative pressure;
a rotary type mounting head (26) that includes (a) a rotor (92) that is rotatable around an axis line, (b) a plurality of suction nozzles (90) that are held so as to move up and down in an axis direction at a plurality of positions on a circumference around the axis line of the rotor (92), and pick up and hold an electronic circuit component using the negative pressure, (c) a rotor rotation device (104) that intermittently rotates the rotor (92), thereby revolving the plurality of suction nozzles (90) which are held on the rotor (92), and stops the respective suction nozzles (90) at predetermined revolving positions, and (d) a head body (98) that holds the rotor rotation device (104) and the rotor (92);
a mounting head moving device (28) that moves the rotary type mounting head (26) with respect to the circuit substrate holding device (22); and
a component mounting control device (34, 400) that controls the rotary type mounting head (26) and the mounting head moving device (28) such that the electronic circuit components are received from the component supply device (24) by the plurality of suction nozzles (90) that are held on the rotor (92) and mounted on the substrate (44) held by the circuit substrate holding device (22),
wherein the rotary type mounting head (26) further includes
(e) a component feeder (200) that, in a state in which the electronic circuit components which are accommodated in a component accommodation section (214) are aligned in a row, sequentially supplies the electronic circuit components from a component supply section (250) to a suction nozzle (90) that is stopped at a component reception position that is one of the predetermined pivoting positions among the plurality of suction nozzles (90), and serves as at least a portion of the component supply device (24);
(f) a positive pressure control valve (280) that sets a suction nozzle (90), among the plurality of suction nozzles (90), which has revolved to the vicinity of a component mounting position that is one of the predetermined revolving positions according to the intermittent rotation of the rotor (92) to a state of being connectable with the positive pressure source (290);
(g) a negative pressure control valve (280) that sets an suction nozzle (90), among the plurality of suction nozzles (90), which has revolved to the vicinity of the component reception position according to the intermittent rotation of the rotor (92) to a state of being connectable with the negative pressure source (292);
(h) a nozzle advancing and retreating device (150, 152) that makes an suction nozzle (90) which is revolved to the vicinity of the component reception position and the vicinity of the component mounting position, among the plurality of suction nozzles (90) that are held on the rotor (92), advance and retreat in an axis direction with respect to the rotor (92); and
(i) a nozzle and positive pressure source connecting and blocking section (310, 312) that is provided in a non-rotation section (98, 302) that does not rotate regardless of rotation of the rotor (92), among a plurality of stop positions in which each of the plurality of suction nozzles (92) that are held on the rotor (92) by the intermittent rotation of the rotor (92) is stopped, in a first setting angle area corresponding to one or more stop positions including the component mounting position, allows a sufficient connection between an suction nozzle (92) at a stop position corresponding to the first setting angle area and the positive pressure source (290), and in a second setting angle area corresponding to one or more stop positions including the component reception position, blocks connection between an suction nozzle (90) at a stop position corresponding to the second setting angle area and the positive pressure source (290).

2. The electronic-circuit-component mounting machine (10) according to claim 1,
wherein a plurality of radial passages (350) is formed in the rotor (92) in a state of extending in a radial shape from a central hole (300) of the rotor (92) to a plurality of positions corresponding to each of the plurality of suction nozzles (90), and
wherein the nozzle and positive pressure source connecting and blocking section (310, 312) further includes
a connection control section (310) having a cutout section (360) that is fit to the central hole (300) so as to be relatively rotatably to the central hole (300), and sets a radial passage (350), among the plurality of radial passages (350), corresponding to one or more suction nozzles (90) at a stop position corresponding to the first setting angle area to a fully open state, according to rotation of the rotor (92), and having a closing section (396) that sets a radial passage (350) corresponding to one or more suction nozzles (90) at a stop position corresponding to the second setting angle area, to a fully closed state; and
a positive pressure source connection passage (312) that makes the cutout section (360) connect with the positive pressure source (290), regardless of a rotation position of the rotor (92).

3. The electronic-circuit-component mounting machine (10) according to claim 2,
wherein, in a state in which one of the plurality of suction nozzles (90) is located at the component mounting position, the cutout section (360) of the connection control section (310) sets a plurality of radial passages (350) corresponding to at least the suction nozzle (90) located at the component mounting position and one or more suction nozzles (90) located on an upstream side from the suction nozzle (90) located at the component mounting position in a rotation direction of the rotor (92), to a fully open state.

4. The electronic-circuit-component mounting machine (10) according to Claim 2 or 3, wherein, in a state in which one of the plurality of suction nozzles (90) is located at the component reception position, the closing section (396) of the connection control section (310) sets a plurality of radial passages (350) corresponding to at least the suction nozzle (90) located at the component reception position and one or more suction nozzles (90) located on an upstream side from the suction nozzle (90) located at the component reception position in a rotation direction of the rotor (92), to a fully closed state.

5. The electronic-circuit-component mounting machine (10) according to any one of claims 2 to 4, further comprising:
a plurality of second radial passages (352) different from first radial passages (350) that are the plurality of radial passages (350) which are formed in the rotor (92) in a state of extending in a radial manner from a central section (300) of the rotor (92) to positions corresponding to each of the plurality of suction nozzles (90); and
a negative pressure source connection passage (314, 330) that makes the second radial passages (352) connect with the negative pressure source (292), regardless of a rotation position of the rotor (92).

6. The electronic-circuit-component mounting machine (10) according to claim 5,
wherein the plurality of first radial passages (350) and the plurality of second radial passages (352) are respectively formed in portions which are separated from each other in a direction parallel to the axis line that is a rotation axis line of the rotor (92), and wherein the positive pressure source connection passage (310, 312) and the negative pressure source connection passage (314, 330) extend from positions in which the first radial passage (350) and the second radial passage (352) respectively connect with each other, in a direction opposite to each other which is parallel to the axis line that is a rotation axis line of the rotor (92).

7. The electronic-circuit-component mounting machine (10) according to any one of claims 1 to 6,
wherein the nozzle advancing and retreating device (152) makes the suction nozzle (90) advance and retreat in parallel to revolving of the suction nozzle (90) according to rotation of the rotor (92) performed by the rotor rotation device (104), in the vicinity of the component reception position.

## Patentansprüche

1. Maschine (10) zum Montieren elektronischer Schaltungsbauteile, die umfasst:
eine Vorrichtung (22) zum Halten eines Schaltungs-Substrats, die ein Schaltungs-Substrat (44) hält;
eine Vorrichtung (24) zur Zufuhr von Bauteilen, die ein elektronisches Schaltungsbauteil zuführt;
eine Überdruck-Quelle (290), die Überdruck zuführt;
eine Unterdruck-Quelle (292), die Unterdruck zuführt;
einen Dreh-Bestückungskopf (26), der a) einen Rotor (92), der um eine Achsenlinie herum gedreht werden kann, b) eine Vielzahl von Ansaugdüsen (90), die an einer Vielzahl von Positionen an einem Umfang um die Achsenlinie des Rotors (92) herum so gehalten werden, dass sie sich in einer Achsenrichtung nach oben und nach unten bewegen und ein elektronisches Schaltungsbauteil unter Verwendung des Unterdrucks aufnehmen und halten, c) eine Rotor-Drehvorrichtung (104), die den Rotor (92) intermittierend dreht und so die an dem Rotor (92) gehaltene Vielzahl von Ansaugdüsen (90) rotieren lässt und die jeweiligen Ansaugdüsen (90) an vorgegebenen Rotationspositionen zum Halten bringt, sowie d) einen Kopf-Körper (78) enthält, der die Rotor-Drehvorrichtung (104) und den Rotor (92) hält;
eine Bestückungskopf-Bewegungsvorrichtung (28), die den Dreh-Bestückungskopf (26) in Bezug auf die Vorrichtung (22) zum Halten eines Schaltungs-Substrats bewegt; und
eine Vorrichtung (34, 400) zur Steuerung von Montage von Bauteilen, die den Dreh-Bestückungskopf (26) und die Bestückungskopf-Bewegungsvorrichtung (28) so steuert, dass die elektronischen Schaltungsbauteile mittels der an dem Rotor (92) gehaltenen Vielzahl von Ansaugdüsen (90) von der Vorrichtung (24) zur Zufuhr von Bauteilen angenommen und an dem Substrat (44) montiert werden, das von der Vorrichtung (22) zum Halten eines Schaltungs-Substrats gehalten wird,
wobei der Dreh-Bestückungskopf (26) des Weiteren enthält:
e) eine Bauteil-Zuführeinrichtung (200), die in einem Zustand, in dem die elektronischen Schaltungsbauteile, die in einem Bauteil-Aufnahme-Teilabschnitt (214) aufgenommen sind, in einer Reihe ausgerichtet sind, die elektronischen Schaltungsbauteile sequenziell von einem Bauteil-Zuführ-Teilabschnitt (250) einer Ansaugdüse (90) der Vielzahl von Ansaugdüsen (90) zuführt, die an einer Bauteil-Annahmeposition zum Halten gebracht wird, die eine der vorgegebenen Drehpositionen ist, und die als wenigstens ein Abschnitt der Vorrichtung (24) zur Zufuhr von Bauteilen dient;
f) ein Überdruck-Steuerungsventil (280), das eine Ansaugdüse (90) der Vielzahl von Ansaugdüsen (90), die entsprechend der intermittierenden Drehung des Rotors (92) in die Nähe einer Bauteil-Montageposition rotiert worden ist, die eine der vorgegebenen Rotationspositionen ist, in einen Zustand versetzt, in dem sie mit der Überdruckquelle (290) verbunden werden kann;
g) ein Unterdruck-Steuerungsventil (280), das eine Ansaugdüse (90) der Vielzahl von Ansaugdüsen (90), die entsprechend der intermittierenden Drehung des Rotors (92) in die Nähe der Bauteil-Annahmeposition rotiert worden ist, in einen Zustand versetzt, in dem sie mit der Unterdruck-Quelle (292) verbunden werden kann;
h) eine Vorrichtung (150, 152) zum Ausfahren und Einfahren einer Düse, die eine Ansaugdüse (90) der an dem Rotor (92) gehaltenen Vielzahl von Ansaugdüsen (90), die in die Nähe der Bauteil-Annahmeposition und die Nähe der Bauteil-Montageposition rotiert worden ist, veranlasst, in einer Achsenrichtung in Bezug auf den Rotor (92) auszufahren und einzufahren; sowie
i) einen Teilabschnitt (310, 312) zum Herstellen und Sperren von Verbindung zwischen einer Düse und der Überdruck-Quelle, der sich in einem nicht drehenden Teilabschnitt (98, 302), der sich unabhängig von Drehung des Rotors (92) nicht dreht, von einer Vielzahl von Haltepositionen befindet, an denen jede der an dem Rotor (92) gehaltenen Vielzahl von Ansaugdüsen (92) durch die intermittierende Drehung des Rotors (92) angehalten wird, in einem ersten Einstellungswinkel-Bereich, der einer oder mehreren Halteposition/en einschließlich der Bauteil-Montageposition entspricht, eine ausreichende Verbindung zwischen einer Ansaugdüse (92) an einer dem ersten Einstellungswinkel-Bereich entsprechenden Halteposition und der Überdruck-Quelle (290) ermöglicht, und in einem zweiten Einstellungswinkel-Bereich, der einer oder mehreren Halteposition/en einschließlich der Bauteil-Annahmeposition entspricht, Verbindung zwischen einer Ansaugdüse (92) an einer dem zweiten Einstellungswinkel-Bereich entsprechenden Halteposition und der Überdruck-Quelle (290) sperrt.

2. Maschine (10) zum Montieren elektronischer Schaltungsbauteile nach Anspruch 1,
wobei eine Vielzahl radialer Kanäle (350) in dem Rotor (92) in einem Zustand ausgebildet ist, in dem sie sich in einer radialen Form von einem Mittelloch (300) des Rotors (92) zu einer Vielzahl von Positionen erstrecken, die jeder der Vielzahl von Ansaugdüsen (90) entsprechen, und
der Teilabschnitt (310, 312) zum Herstellen und Sperren von Verbindung zwischen einer Düse und der Überdruck-Quelle des Weiteren enthält:
einen Teilabschnitt (310) zur Steuerung von Verbindung, der einen ausgeschnittenen Teilabschnitt (360) aufweist, der so in das Mittelloch (300) passt, dass er relativ zu dem Mittelloch (300) gedreht werden kann, und der von der Vielzahl radialer Kanäle (350) einen radialen Kanal (350), der einer oder mehreren Ansaugdüse/n an einer Halteposition entspricht, die dem ersten Einstellungswinkel-Bereich entspricht, entsprechend Drehung des Rotors in einen vollständig geöffneten Zustand versetzt, sowie einen Verschluss-Teilabschnitt (396) aufweist, der einen radialen Kanal (350), der einer oder mehreren Ansaugdüse/n (90) an einer Halteposition entspricht, die dem zweiten Einstellungswinkel-Bereich entspricht, in einen vollständig geschlossenen Zustand versetzt; und
einen Kanal (312) zur Verbindung mit der Überdruck-Quelle, der den ausgeschnittenen Teilabschnitt (360) unabhängig von einer Drehungsposition des Rotors (92) mit der Überdruck-Quelle (290) verbindet.

3. Maschine (10) zum Montieren elektronischer Schaltungsbauteile nach Anspruch 2,
wobei in einem Zustand, in dem sich eine der Vielzahl von Ansaugdüsen (90) an der Bauteil-Montageposition befindet, der ausgeschnittene Teilabschnitt (360) des Teilabschnitts (310) zur Steuerung von Verbindung eine Vielzahl radialer Kanäle (350), die wenigstens der an der Bauteil-Montageposition befindlichen Ansaugdüse (90) und einer oder mehreren Ansaugdüse/n (90) entspricht, die sich an einer von der an der Bauteil-Montageposition befindlichen Ansaugdüse (90) in einer Drehungsrichtung des Rotors (92) stromauf liegenden Seite befindet/befinden, in einen vollständig geöffneten Zustand versetzt.

4. Maschine (10) zum Montieren elektronischer Schaltungsbauteile nach Anspruch 2 oder 3,
wobei in einem Zustand, in dem sich eine der Vielzahl von Ansaugdüsen (90) an der Bauteil-Annahmeposition befindet, der Verschluss-Teilabschnitt (396) des Teilabschnitts (310) zur Steuerung von Verbindung eine Vielzahl radialer Kanäle (350), die wenigstens der an der Bauteil-Annahmeposition befindlichen Ansaugdüse (90) und einer oder mehreren Ansaugdüse/n (90) entspricht, die sich an einer von der an der Bauteil-Annahmeposition befindlichen Ansaugdüse (90) in einer Drehungsrichtung des Rotors (92) stromauf liegenden Seite befindet/befinden, in einen vollständig geschlossenen Zustand versetzt.

5. Maschine (10) zum Montieren elektronischer Schaltungsbauteile nach einem der Ansprüche 2 bis 4, die des Weiteren umfasst:
eine Vielzahl zweiter radialer Kanäle (352), die sich von den ersten radialen Kanälen (350) unterscheiden, die die Vielzahl radialer Kanäle (350) sind, die in dem Rotor (92) in einem Zustand ausgebildet sind, in dem sie sich radial von einem Mittelabschnitt (300) des Rotors (92) zu Positionen erstrecken, die jeder der Vielzahl von Ansaugdüsen (90) entsprechen; sowie
einen Kanal (314, 330) zur Verbindung mit der Unterdruck-Quelle, der die zweiten radialen Kanäle (352) unabhängig von einer Drehungsposition des Rotors (92) mit der Unterdruck-Quelle (292) verbindet.

6. Maschine (10) zum Montieren elektronischer Schaltungsbauteile nach Anspruch 5,
wobei die Vielzahl erster radialer Kanäle (53) und die Vielzahl zweiter radialer Kanäle (352) jeweils in Abschnitten ausgebildet sind, die voneinander in einer Richtung parallel zu der Achsenlinie getrennt sind, die eine Drehachsenlinie des Rotors (92) ist, und der Kanal (310, 312) zur Verbindung mit der Überdruck-Quelle und der Kanal (314, 330) zur Verbindung mit der Unterdruck-Quelle sich von Positionen, an denen der erste radiale Kanal (350) und der zweite radiale Kanal (352) jeweils miteinander verbunden sind, in einer Richtung entgegengesetzt zueinander erstrecken, die parallel zu der Achsenlinie ist, die eine Drehachsenlinie des Rotors (92) ist.

7. Maschine (10) zum Montieren elektronischer Schaltungsbauteile nach einem der Ansprüche 1 bis 6,
wobei die Vorrichtung (152) zum Ausfahren und Einfahren einer Düse die Ansaugdüse (90) parallel zum Rotieren der Ansaugdüse (90) entsprechend durch die Rotor-Drehvorrichtung (104) durchgeführter Drehung des Rotors (92) in der Nähe der Bauteil-Annahmeposition ausfahren und einfahren lässt.

## Revendications

1. Machine de montage de composants de circuits électroniques (10) comprenant :
un dispositif de maintien de substrat de circuit (22) qui maintient un substrat de circuit (44),
un dispositif de délivrance de composant (24) qui délivre un composant pour circuit électronique,
une source de pression positive (290) qui fournit une pression positive,
une source de pression négative (292) qui fournit une pression négative,
une tête de montage de type rotative (26) qui inclut (a) un rotor (92) qui peut tourner autour d'un axe, (b) une pluralité de buses d'aspiration (90) qui sont maintenues de sorte à se déplacer vers le haut et vers le bas dans la direction d'un axe vers une pluralité de positions sur une circonférence autour de l'axe du rotor (92) et qui prélèvent et maintiennent un composant pour circuit électronique en utilisant la pression négative, (c) un dispositif de rotation de rotor (104) qui fait tourner le rotor (92) de façon intermittente, en faisant tourner la pluralité de buses d'aspiration (90) qui sont maintenues sur le rotor (92), et qui stoppe les buses d'aspiration (90) respectives à des positions de révolution prédéterminées et (d) un corps de tête (98) qui maintient le dispositif de rotation du rotor (104) et le rotor (92),
un dispositif de déplacement de tête de montage (28) qui déplace la tête de montage de type rotative (26) par rapport au dispositif de maintien de substrat de circuit (22), et
un dispositif de commande de montage de composant (34, 400) qui commande la tête de montage de type rotative (26) et le dispositif de déplacement de tête de montage (28) de sorte à ce que les composants pour circuit électronique soient reçus en provenance du dispositif de délivrance de composant (24) par la pluralité de buses d'aspiration (90) qui sont maintenues sur le rotor (92) et montées sur le substrat (44) maintenu par le dispositif de maintien de substrat de circuit (22),
dans lequel la tête de montage de type rotative (26) inclut en outre :
(e) un dispositif d'alimentation en composants (200) qui, dans une situation dans laquelle les composants pour circuit électronique, qui sont logés dans une section de logement de composants (214), sont alignés en une rangée, délivre séquentiellement les composants pour circuit électronique à partir d'une section d'alimentation en composants (250) à une buse d'aspiration (90) qui est stoppée au niveau d'une position de réception de composant qui représente l'une des positions prédéterminées de pivotement parmi la pluralité de buses d'aspiration (90) et qui sert au moins en tant que partie du dispositif de délivrance de composant (24),
(f) une vanne de commande de pression positive (280) qui positionne une buse d'aspiration (90) parmi la pluralité de buses d'aspiration (90), qui a tourné au voisinage d'une position de montage de composant, laquelle représente l'une des positions prédéterminées de révolution en fonction de la rotation intermittente du rotor (92) pour pouvoir être reliée à la source de pression positive (290),
(g) une vanne de commande de pression négative (280) qui positionne une buse d'aspiration (90) parmi la pluralité de buses d'aspiration (90), qui a tourné au voisinage d'une position de réception de composant en fonction de la rotation intermittente du rotor (92) pour pouvoir être reliée à la source de pression négative (292),
(h) un dispositif d'avance et de recul de buse (150, 152) qui fait avancer et reculer une buse d'aspiration (90) que l'on fait tourner au voisinage de la position de réception de composant et au voisinage de la position de montage de composant, parmi la pluralité de buses d'aspiration (90) qui sont maintenues sur le rotor (92), dans la direction de l'axe par rapport au rotor (92), et
(i) une section de raccordement et de blocage de buse et de source de pression positive (310, 312) qui est prévue dans une section sans rotation (98, 302) qui ne tourne pas indépendamment de la rotation du rotor (92), parmi la pluralité de positions d'arrêt dans lesquelles chacune de la pluralité de buses d'aspiration (90) qui sont maintenues sur le rotor (92) par la rotation intermittente du rotor (92) est stoppée, dans une première zone d'angle de réglage correspondant à une ou plusieurs positions d'arrêt incluant la position de montage de composant, qui permet une connexion suffisante entre une buse d'aspiration (90) au niveau d'une position d'arrêt correspondant à la première zone d'angle de réglage et la source de pression positive (290), et dans une seconde zone d'angle de réglage correspondant à une ou plusieurs positions d'arrêt incluant la position de réception de composant, qui bloque la connexion entre une buse d'aspiration (90) maintenue au niveau d'une position d'arrêt correspondant à la seconde zone d'angle de réglage et la source de pression positive (290) .

2. Machine de montage de composants de circuits électroniques (10) selon la revendication 1,
dans laquelle plusieurs passages radiaux (350) sont formés dans le rotor (92) pour pouvoir se déployer dans une configuration radiale depuis l'alésage central (300) du rotor (92) vers une pluralité de positions correspondant à chacune de la pluralité de buses d'aspiration (90), et
dans laquelle la section de raccordement et de blocage de buse et de source de pression positive (310, 312) inclut en outre :
une section de commande de connexion (310) comportant une section de découpe (360) qui est ajustée à l'alésage central (300) de façon à pouvoir tourner relativement par rapport à l'alésage central (300), et qui positionne un passage radial (350), parmi la pluralité de passages radiaux (350) correspondant à une ou plusieurs buses d'aspiration (90) au niveau d'une position d'arrêt correspondant à un état entièrement ouvert à la première zone d'angle de réglage, en fonction de la rotation du rotor (92) et comportant une section de fermeture (396) qui positionne un passage radial (350), correspondant à une ou plusieurs buses d'aspiration (90) au niveau d'une position d'arrêt correspondant à un état entièrement fermé à la seconde zone d'angle de réglage, et
un passage de raccordement de source de pression positive (312) qui relie la section de découpe (360) à la source de pression positive (290) indépendamment de la position rotation du rotor (92).

3. Machine de montage de composants de circuits électroniques (10) selon la revendication 2,
dans laquelle, dans un état dans lequel l'une de la pluralité de buses d'aspiration (90) est située au niveau de la position de réception de composant, la section de découpe (360) de la section de commande de connexion (310) positionne à l'état complètement ouvert une pluralité de passages radiaux (350) correspondant à au moins la buse d'aspiration (90) située à la position de montage de composants et une ou plusieurs buses d'aspiration (90) situées en amont de la buse d'aspiration (90) située à la position de montage de composants dans la direction de rotation du rotor (92).

4. Machine de montage de composants de circuits électroniques (10) selon la revendication 2 ou la revendication 3,
dans laquelle, dans un état dans lequel l'une de la pluralité de buses d'aspiration (90) est située au niveau de la position de montage de composant, la section de fermeture (396) de la section de commande de connexion (310) positionne à l'état complètement fermé une pluralité de passages radiaux (350) correspondant à au moins la buse d'aspiration (90) située à la position de réception de composant et une ou plusieurs buses d'aspiration (90) situées en amont par rapport à la buse d'aspiration (90) située à la position de réception de composant dans la direction de rotation du rotor (92).

5. Machine de montage de composants de circuits électroniques (10) selon l'une quelconque des revendications 2 à 4, comprenant en outre :
une pluralité de seconds passages radiaux (352), différents des premiers passages radiaux (350), lesquels représentent la pluralité de passages radiaux (350) qui sont formés dans le rotor (92) pour se déployer radialement depuis la section centrale (300) du rotor (92) vers des positions correspondant à chacune de la pluralité de buses d'aspiration (90), et
un passage de raccordement de source de pression négative (314, 330) qui relie les seconds passages radiaux (352) à la source de pression négative (292) indépendamment de la position de rotation du rotor (92).

6. Machine de montage de composants de circuits électroniques (10) selon la revendication 5,
dans laquelle la pluralité de premiers passages radiaux (350) et la pluralité de seconds passages radiaux (352) sont respectivement formées dans des parties qui sont séparées l'une de l'autre dans une direction parallèle à l'axe représentant l'axe de rotation du rotor (92), et
dans laquelle le passage de raccordement de source de pression positive (310, 312) et le passage de raccordement de source de pression négative (314, 330) s'étendent depuis des positions dans lesquelles le premier passage radial (350) et le second passage radial (352) se relient respectivement l'un à l'autre dans une direction opposée à l'autre qui est parallèle à l'axe représentant l'axe de rotation du rotor (92).

7. Machine de montage de composants de circuits électroniques (10) selon l'une quelconque des revendications 1 à 6,
dans laquelle le dispositif d'avance et de recul de buses (152) fait avancer et reculer la buse d'aspiration (90) parallèlement à la révolution de la buse d'aspiration (90) en fonction de la rotation du rotor (92) réalisée par le dispositif de rotation de rotor (104) au voisinage de la position de réception de composant.
